## Europäisches Patentamt
## European Patent Office
## Office européen des brevets

(19)

(11) Veröffentlichungsnummer: **0 217 162**
**B1**

(12)

# EUROPÄISCHE PATENTSCHRIFT

(45) Veröffentlichungstag der Patentschrift:
**06.12.89**

(21) Anmeldenummer: 86112160.6

(22) Anmeldetag: 02.09.86

(51) Int. Cl.⁴: **H05K 7/14**, H05K 7/18

(54) Einrichtung zur Fixierung von Führungsschienen für elektrische Inneneinbauten mittels Rasterschiene.

(30) Priorität: **05.09.85 DE 3531717**

(43) Veröffentlichungstag der Anmeldung:
**08.04.87 Patentblatt 87/15**

(45) Bekanntmachung des Hinweises auf die Patenterteilung:
**06.12.89 Patentblatt 89/49**

(84) Benannte Vertragsstaaten:
**CH DE FR GB IT LI NL**

(56) Entgegenhaltungen:
**EP-A- 0 105 150
DE-A- 3 110 717
DE-B- 1 182 316
DE-B- 1 271 793
DE-B- 1 282 758**

(73) Patentinhaber: **Siemens Aktiengesellschaft,
Wittelsbacherplatz 2, D-8000 München 2(DE)**
Patentinhaber: **ANT Nachrichtentechnik GmbH,
Gerberstrasse 33, D-7150 Backnang(DE)**

(72) Erfinder: **Riedl, Friedrich, Dipl.-Ing.(FH),
Herbststrasse 15, D-8035 Gauting(DE)**
Erfinder: **Mayer, Franz, Wasti-Witt-Strasse 11,
D-8000 München 21(DE)**
Erfinder: **Hirsch, Gerhard, Ing. grad., Häfnersweg 66,
D-7150 Backnang(DE)**
Erfinder: **Latsch, Wolfgang, Dipl.-Ing. (FH),
Hermann-Hesse-Weg 2, D-7151 Auenwald(DE)**
Erfinder: **Stephan, Roland, Ing. grad.,
Glasäckerstrasse 33, D-7151 Allmersbach I.T.(DE)**

(74) Vertreter: **Mehl, Ernst, Dipl.-Ing., Postfach 22 13 17,
D-8000 München 22(DE)**

## Beschreibung

Die Erfindung betrifft eine Einrichtung zur Fixierung von Führungsschienen für elektrische Inneneinbauten auf einer Profil-Trägerplatte, mit mindestens einer aus Kunststoff bestehenden Rasterschiene, die an der den Führungsschienen zugekehrten Seite mit einem Teilungsraster und Kennzeichnungen z.B. in Form von Zählnummern ausgebildet und in eine mit mindestens einer Hinterschneidung versehene Nut der Profil-Trägerplatte eingesetzt ist. Eine derartige Einrichtung geht aus der DE-OS 31 10 717 als bekannt hervor.

Zum Einbau elektrischer Inneneinbauten, wie z.B. Leiterplatten, Steckbaugruppen oder Einschübe, in Einschub- oder Baugruppenträger, z.B. Gehäuse für elektrische Geräte, werden häufig Führungsschienen mit einer Führungsrille zum Einschieben oder Einstecken der Inneneinbauten verwendet. Um die Inneneinbauten an verschiedenen Plätzen innerhalb eines Teilungsrasters anordnen und die Führungsschienen an allen möglichen Steckplätzen im Raster seitlich fixieren zu können, benutzt man Rasterschienen, die mit einem Teilungsraster ausgebildet sind, in das die Führungsschienen eingreifen.

Aus der DE-PS 1 271 793 ist eine Geräteeinheit zur Aufnahme von Steckbaugruppen bekannt, bei der das Teilungsraster für die einrastbar ausgebildeten und aus elastischem Kunststoff bestehenden Führungsschienen von zwei parallelen Schlitzreihen gebildet ist, welche in zwei einander gegenüberliegenden, als profilierte Aufnahmebleche ausgebildete Begrenzungswände der Geräteeinheit vorgesehen sind. Bei dieser Geräteeinheit sind also Boden- und Deckplatte mit Schlitzen ausgebildet. Dies ist aber bei vielen Geräten und/oder Einsätzen, z.B. bei mechanisch stabilen, mechanisch und elektrisch dichten Gehäusen und/oder beim Einsatz im Freien nicht möglich. Außerdem sind die Schlitzreihen unter den Führungsschienen und innerhalb des die Steckbaugruppen aufnehmenden Bereiches der Geräteeinheit vorgesehen, so daß hierdurch auch die optische Erkennbarkeit des Teilungsrasters beim Auswechseln oder Nachrüsten von Steckbaugruppen beeinträchtigt ist.

Die DE-PS 1 182 316 zeigt einen Einschubträger, der ebenfalls mit Führungsschienen für Baugruppen oder Steckkarten und einem zweireihigen Teilungsraster für die Führungsschienen ausgebildet ist. Dabei sind in T-förmige Längsnuten der Rasterschienen Kunststoffstreifen mit Stegen eingeschoben, die das Teilungsraster bilden. Bei diesem Einschubträger sind die Kunststoffstreifen mit dem Teilungsraster nur seitlich in die Rasterschienen einzuschieben und ebenfalls innerhalb des die Baugruppen oder Steckkarten aufnehmenden Bereiches, d.h. somit also unter den Führungsschienen liegend angeordnet. Dies beeinträchtigt außer der optischen Erkennbarkeit des Teilungsrasters im bestückten Zustand auch dessen Montage- und Auswechselmöglichkeiten, z.B. bei Änderung des Teilungsrasters, da das Einsetzen und Entfernen des Teilungsrasters nur dann möglich ist, wenn eine Seitenwand des Einschubträgers noch nicht angebracht ist bzw. erst entfernt wird.

Schließlich ist aus der DE-OS 31 10 717 ein weiterer aus einer Profil-Trägerplatte bestehender Baugruppenträger mit Führungsleisten und zwei Rastschienen für Leiterplatten bekannt, bei dem die mit Kennzeichnungen für das Teilungsraster versehenen Rastschienen jeweils in eine mit einer Hinterschneidung ausgebildete Nut der Profil-Trägerplatte eingesetzt und dort durch in dieselbe Nut eingreifende Rastnasen der Führungsleisten fixiert sind. Auch bei diesem bekannten Baugruppenträger sind die beiden Rastschienen innerhalb des die Leiterplatten aufnehmenden Bereichs und unter den Führungsleisten liegend angeordnet, so daß auch hier neben der optischen Erkennbarkeit des Teilungsrasters im bestückten Zustand die Montage- und Auswechselmöglichkeiten der Rastschienen beeinträchtigt sind. Außerdem erfolgt dort die Fixierung der Rastschienen erst durch das Einsetzen der Führungsleisten.

Der Erfindung liegt die Aufgabe zugrunde, bei einer Einrichtung der eingangs genannten Art die Ausbildung sowie Montage- und Befestigungsmöglichkeiten der Rasterschiene zu vereinfachen und die optische Erkennbarkeit des Teilungsrasters auch im bestückten Zustand der Einrichtung zu gewährleisten.

Diese Aufgabe wird bei einer Einrichtung der eingangs genannten Art gemäß der Erfindung durch folgende Merkmale gelöst:

a) die Rasterschiene besteht aus einem im Querschnitt etwa U-förmigen Teil mit federnden Seitenschenkeln an einem das Teilungsraster aufweienden Mittelteil,

b) die Rasterschiene ist mit ihren Seitenschenkeln von oben her in die Nut der Profil-Trägerplatte einsetzbar,

c) mindestens ein Seitenschenkel ist an seinem freien Ende mit einem nach außen gerichteten, sich in Längsrichtung der Rasterschiene erstreckenden und an der Hinterschneidung der Nut einrastenden Widerhaken ausgebildet,

d) die Nut der Profil-Trägerplatte ist außerhalb des die Inneneinbauten aufnehmenden Bereiches am Anfang bzw. Ende der Führungsschienen vorgesehen,

e) die Breite der Öffnung der Nut entspricht etwa dem Abstand der Außenflächen der Seitenschenkel der Rasterschiene,

f) die Führungsschienen sind lediglich mit einem an ihrem Anfang bzw. Ende vorgesehenen und auf die Rasterschiene zu gerichteten Haken in das als Lochraster ausgebildete Teilungsraster eingehängt.

Bei einer derartigen Einrichtung ist die Rasterschiene in einfacher Weise als U-förmiges Kunststoffteil ausgebildet, das mit seinen federnden Seitenschenkeln von oben her in eine Nut der Profil-Trägerplatte eingesetzt werden kann. Dadurch ergibt sich eine sehr einfache Montage der Rasterschiene in der Profil-Trägerplatte, wobei ein Einschieben der Rasterschiene in die Profil-Trägerplatte von der Seite her vermieden wird. Dies bedeutet, daß die Rasterschiene in vorteilhafter Weise auch in eine mit zwei parallelen und zum Profilverlauf senkrechten Seiten wänden versehene Trägerplatte, also z.B. auch in ein Gehäuse mit Seitenwänden, ohne weiteres einsetzbar ist bzw. ebenso einfach aus der Profilierung herausnehmbar ist. Damit ergeben sich einfache Auswechslungs- oder Nachrüstungsmöglichkeiten. Da ferner noch mindestens einer der federnden Seitenschenkel der U-förmigen Rasterschiene mit einem an einer Hinterschneidung der aufnehmenden Nut einrastenden Widerhaken ausgebildet ist, ist die Rasterschiene auch in einfacher Weise in dieser Nut fixierbar, d.h. ohne weitere Maßnahmen, wie z.B. des Eingriffs der Führungsschiene in die Rasterschiene und unabhängig von anderen Komponenten des Führungssystems gehalten. Die Fixierung der Rasterschiene in ihrer Längsrichtung erfolgt zweckmäßigerweise dadurch, daß die Rasterschiene auf passende Länge, z.B. auf eine dem Abstand von parallelen Seitenwänden der Profil-Trägerplatte oder einer Gehäusebreite entsprechende Länge abgeschnitten wird. Die bei einer erfindungsgemäßen Einrichtung vorgesehene U-förmige Rasterschiene ist somit selbstklemmend in der weitere Komponenten eines Führungssystems aufnehmenden Profil-Trägerplatte gehalten und daher besonders gut für ein Führungssystem geeignet, dessen Einzelkomponenten in Einschnapp- oder Einrastmontagetechnik an der Trägerplatte angebracht werden.

Ein weiterer Vorteil ergibt sich bei einer derartigen Einrichtung dadurch, daß die die Rasterschiene aufnehmende Nut außerhalb des die Inneneinbauten aufnehmenden Bereiches am Anfang bzw. am Ende der Führungsschienen vorgesehen ist. Daher wird das auf dem Mittelteil der U-förmigen Rasterschiene angeordnete Teilungsraster auch im bestückten Zustand der Führungsschienen bzw. der Profil-Trägerplatte nicht durch die Inneneinbauten abgedeckt. Da außerdem noch die Führungsschienen lediglich mit einem an ihrem Anfang bzw. Ende vorgesehenen und auf die Rasterschiene zu gerichteten Haken in das als Lochraster ausgebildete Teilungsraster eingehängt sind, bleibt das Teilungsraster auch dann noch, wenn die Führungsschienen in die Rasterschiene eingreifen, optisch erkennbar. Dies bedeutet, daß die Kennzeichnungen des Teilungsrasters, z.B. Zählnummern, stets gut ablesbar sind. Damit ist stets - sowohl bei der Bestückung bzw. bei der Montage als auch im bestückten Zustand sowie bei Auswechslungen - eine Orientierung über das Teilungsraster gegeben.

Zur weiteren Orientierungshilfe ist es vorteilhaft, wenn an beiden Seitenschenkeln der Rasterschiene zusätzliche Kennzeichnungen für das Teilungsraster vorgesehen sind. Diese zusätzlichen Kennzeichnungen können zweckmäßigerweise in Höhe einer Zehnerteilung und gegebenenfalls auch in Höhe einer Fünferteilung vorgesehen sein und dann z.B. aus einem längeren bzw. einem kürzeren Strich oder einer Rippe gebildet sein.

Hinsichtlich der Fixierung der Rasterschiene in der Nut der Profil-Trägerplatte ist es von Vorteil, wenn die Seitenschenkel der Rasterschiene etwas nach außen gespreizt sind, so daß sie mit dem Mittelteil einen Winkel von etwas mehr als 90° einschließen.

Weitere vorteilhafte Ausgestaltungen des Gegenstandes des Patentanspruchs 1 sind in den übrigen Unteransprüchen angegeben.

Die Erfindung ist im folgenden anhand eines in der Zeichnung dargestellten Ausführungsbeispiels der Einrichtung und der Anwendung einer solchen Einrichtung beim Aufbau eines Gehäuses für elektrische Geräte näher beschrieben.

Es zeigen

Fig. 1 ein Gehäuse für elektrische Geräte im Querschnitt und im geöffneten Zustand, d.h. ohne Frontplatte und ohne Rückwand,

Fig. 2 eine Einzelheit A nach Fig.1 in perspektivischer Darstellung mit einem Bruchstück einer in eine Profil-Trägerplatte einsetzbaren Rasterschiene.

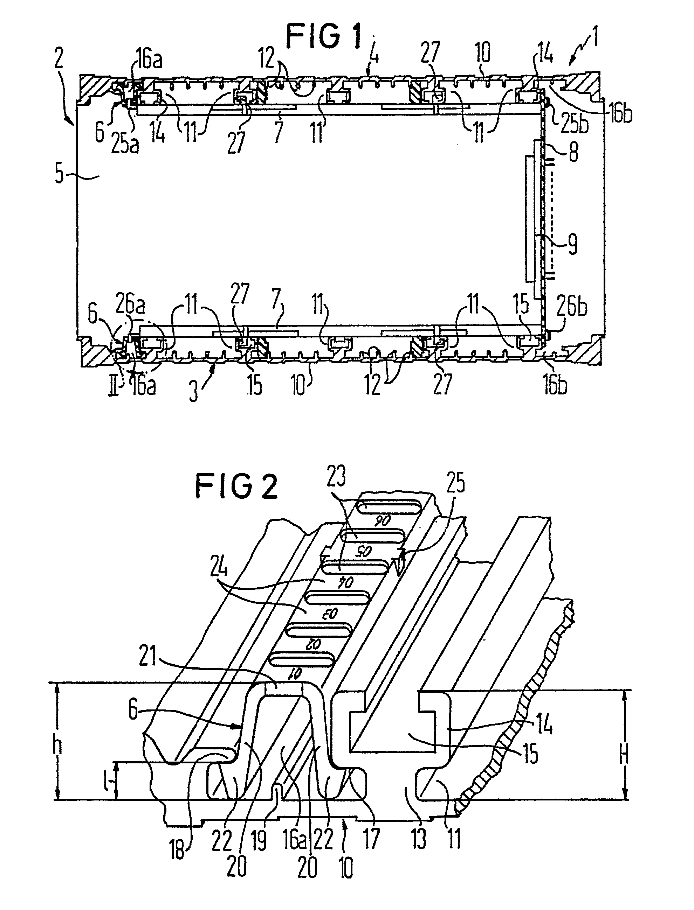

Das Gehäuse 1 in Fig. 1 hat einen kastenförmigen Rahmen oder Mantel 2, der aus zwei einander gegenüberliegenden Mittelteilen, nämlich einer Bodenplatte 3 und einer Deckplatte 4, sowie aus zwei damit dicht verbundenen Seitenwänden, von denen in Fig.1 nur die Seitenwand 5 zu sehen ist, besteht. An den beiden offenen Seiten ist der Gehäusemantel mit einer abschraubbaren oder abklappbaren Frontplatte und Rückwand,die beide nicht dargestellt sind,dicht verschließbar. Dabei kann die Wasser- und HF-Dichtigkeit des Gehäuses dadurch gewährleistet werden, daß die Mittelteile und die Seitenwände an den vier Kanten durch geeignete Schweißverfahren dicht verbunden sind und eine kombinierte Gummi-Draht-Dichtungsschnur jeweils in eine Nut der Frontplatte und der Rückwand eingelegt ist. Insgesamt ist das Gehäuse in seinem grundsätzlichen Aufbau wie die z.B. in der DE-AS 25 23 292, der DE-PS 25 38 314 und der DE-PS 24 43 122 beschriebene und unter dem Warenzeichen "SIDISET" bekanntgewordene Gehäusebaureihe ausgebildet, wobei für das vorliegende Gehäuse gegebenenfalls einzelne Teile, wie z.B. die Frontplatte und die Rückwand, aus dem bekannten System verwendet werden können. Die die Inneneinbauten, wie z.B. nicht dargestellte Leiterplatten, Steckbaugruppen oder Einschübe tragenden Mittelteile 3,4 sind jeweils von einer Profil-Trägerplatte aus einem Aluminium-Strangpreßprofil mit einem zu zwei einander gegenüberliegenden Plattenrändern, hier zur Front- und zur Rückseite parallelen Profilverlauf in Richtung der Gehäusebreite gebildet. Alle im Gehäusemantel 2 aufgenommenen Inneneinbauten sind mit Führungs-, Rast- und Verdrahtungsmitteln an den die Boden- und die Deckplatte 3 bzw. 4 bildenden, in besonderer Weise gestalteten Profil-Trägerplatten angeordnet, die hier also zusammen mit den genannten Mitteln die Montage- und Halterungseinrichtung für die Inneneinbauten bilden.

Diese Einrichtung besteht im vorliegenden Fall also aus beiden Mittelteilen 3 und 4, d.h. aus zwei Profil-Trägerplatten 10, die in gleicher Weise mit jeweils einer Rasterschiene 6 und mehreren, paarweise einander parallel gegenüberliegenden Führungsschienen 7 ausgebildet sind, so daß jeweils zwischen einer unteren und der senkrecht direkt darüber liegenden Führungsschiene z.B. eine Leiterplatte oder eine Steckbaugruppe in das Gehäuse 1 einschiebbar ist. Außerdem ist noch eine gemeinsame Verdrahtungsplatte 8 zur Verdrahtung der Leiterplatten oder Steckbaugruppen untereinander vorgesehen, wobei die Verdrahtungsplatte -wie auch die Leiterplatten oder Steckbaugruppen - mit einer Steckerleiste 9 ausgebildet ist.

Die einzelnen Komponenten, nämlich die Mittelteile 3 und 4, die Rasterschiene 6, die Führungsschienen 7 und die Verdrahtungsplatte 8 sind im einzelnen nun wie folgt gestaltet. Die für die Mittelteile vorgesehene Profil-Trägerplatte 10 hat einen regelmäßigen Profilverlauf mit gleichmäßig innerhalb des die Inneneinbauten aufnehmenden Bereiches verteilten Profilrippen 11 und Kühlrippen 12. Dabei sind auf der hier etwa 2 mm dicken Profil-Trägerplatte 10 fünf Profilrippen 11 vorgesehen, die in gleichem Abstand voneinander angeordnet sind und zu zwei einander parallel gegenüberliegenden Plattenrändern, also zur Front- und zur Rückseite, und zueinander parallel verlaufen. Zwischen jeweils zwei Profilrippen 11 sind vier Kühlrippen 12 vorgesehen, die in gleichem Abstand voneinander angeordnet sind und parallel zu den Profilrippen und zueinander verlaufen. Die Profilrippen 11 bestehen aus einem zur Ebene der Profil-Trägerplatte 10 senkrechten Steg 13 und einer auf diesem Steg liegend angeordneten C-Profilschiene 14 mit einer zu den Inneneinbauten hin offenen T-Nut 15, wobei die C-Profilschiene 14 über beide senkrechte Seiten des Steges hinausragt und hier symmetrisch in Bezug auf eine Symmetrielinie des Steges angeordnet ist. Dabei bildet der Steg der Profilrippen als Ständer oder Stütze für die die eigentliche Auflage für die Inneneinbauten bzw. deren Führungsmittel übernehmende C-Profilschiene eine Art Wärmeableitsteg, während insbesondere durch die Form der Profilrippen und durch die zwischen den Profilrippen angeordneten Kühlrippen von der Höhe etwa des Steges vor allem die Oberfläche zur Wärmeabsorption vergrößert wird. Zudem wird dadurch eine hohe Formstabilität bei möglichst geringem Gewicht der Profil-Trägerplatte erreicht. Außerdem bietet die Form der C-Profilschiene 14 vielfältige variable Befestigungsmöglichkeiten für die Inneneinbauten bzw. deren Führungsmittel. Die Inneneinbauten können schraubenlos - falls erforderlich aber auch schraubbar mittels Gleit - oder Schiebemuttern - mit Hilfe der durch Einrasten oder Einschnappen in den C-Profilschienen 14 zu halternden Führungsschienen 7 an beliebigen Stellen der Profil-Trägerplatte befestigt werden. Damit bilden die C-Profilschienen gleichzeitig auch Montageschienen, welche die Anwendung einer Einschnapp-Montagetechnik für die Gehäuseeinbauten bzw. deren Führungs- und Rastmittel ermöglichen. Hierzu ist die Profil-Trägerplatte 10 außerhalb des die Inneneinbauten aufnehmenden Bereiches, also am Anfang bzw. am Ende der Führungsschienen 7, zwischen den beiden äußersten Profilrippen 11 und dem jeweiligen Rand der Trägerplatte an der Front- bzw. an der Rückseite des Gehäuses noch mit einer zu den Inneneinbauten hin offenen Nut 16a bzw. 16b ausgebildet. Diese Nut ist einerseits durch die äußere, eine Hinterschneidung 17 bildende Schulter der entsprechenden C-Profilschiene 14 der äußersten Profilrippe 11 und andererseits durch eine hierzu gegenüberliegende Hinterschneidung 18 der Trägerplatte 10 T-förmig gestaltet und weist etwa in ihrer Mitte eine Rippe 19 auf, die gegenüber den Kühlrippen 12 etwas niedriger ist. Die nahe der Gehäusefrontseite befindliche Nut 16a dient zum Einsetzen der mit einem Teilungsraster ausgebildeten Rasterschiene 6, während in die nahe der Gehäuserückseite befindliche Nut 16b die gemeinsame Verdrahtungsplatte 8 senkrecht zur Trägerplatte und zur Einschubrichtung der Inneneinbauten stehend und gegebenenfalls an der C-Profilschiene 14 der anderen äußersten Profilrippe 11 anliegend eingesetzt ist. Die Rasterschiene 6 besteht aus einem im Querschnitt U-förmigen Kunststoffteil, dessen federnde Seitenschenkel 20 etwas nach außen gespreizt sind, so daß sie mit dem das Teilungsraster aufweisenden Mittelteil 21 einen Winkel von etwas mehr als 90° einschließen. Außerdem sind die Seitenschenkel 20 der Rasterschiene 6 an ihrem freien Ende mit einem nach außen gerichteten Widerhaken 22 versehen, wobei die Länge l der Widerhaken etwa gleich dem Höhenabstand der Hinterschneidungen 17,18 der Nut 16a,16b von der Ebene der Trägerplatte 10 ist. Damit ist die von oben her in die Nut 16a einsetzbare und mit ihrer Länge der Gehäusebreite entsprechende Rasterschiene 6 unter Selbstklemmung in der Nut fixierbar. Dabei ist die lichte Breite der Öffnung der Nut 16a so gewählt, daß sie etwa dem Abstand der Außenflächen der Seitenschenkel 20 ist. Wie insbesondere aus Fig.2 ersichtlich ist, ist die Höhe h der Seitenschenkel 20 etwa gleich der doppelten Breite des Mittelteiles 21 und entspricht etwa gleich der Höhe H der von dem Steg 13 mit der C-Profilschiene 14 gebildeten Profilrippe 11. Hierbei sind die Höhe h der Seitenschenkel 20 und die Tiefe der Nut 16a noch so gewählt, daß die Seitenschenkel maximal bis etwa zur Hälfte in die Nut eintauchen. Das Teilungsraster auf dem Mittelteil 21 der Rasterschiene 6 besteht aus einem Lochraster, das von einer Vielzahl von mit ihrer Längsrichtung parallel zueinander und senkrecht zu den Seitenschenkeln 20, also quer zur Nut 16a in Einschubrichtung der Inneneinbauten sich über die gesamte Breite des Mittelteiles erstreckenden Langlöchern 23 gebildet ist. Zur Kennzeichnung des Teilungsrasters sind auf den zwischen den Aussparungen 23 stehenbleibenden Stegen 24 fortlaufende Zählnummern und/oder Buchstaben vorgesehen. Außerdem sind an beiden Seitenschenkeln 20 der Rasterschiene 6 noch zusätzliche Kennzeichnungen für das Teilungsraster vorgesehen. Diese sind in Höhe einer Fünfterteilung sowie in Höhe einer Zehnerteilung angeordnet und von einer kürzeren Rippe 25 oder einem Strich bzw. von einer längeren Rippe gebildet und bleiben infolge der nur zur Hälfte in die Nut 16a eintauchenden Rasterschiene stets gut sichtbar.

Die Führungsschienen 7 sind an beiden Enden mit auf die Rasterschiene 6 zu gerichteten Haken 26a bzw. 26b versehen und sind lediglich mit dem Haken 26a an dem einen Ende in das Teilungsraster der Rasterschiene 6 und mit dem Haken 26b an dem anderen Ende in eine der im Teilungsraster der Rasterschiene angeordneten Aussparungen der Verdrahtungsplatte 8 eingehängt. Dadurch wird im Zusammenwirken mit der in gleicher Weise ausgebildeten Deckplatte 4 des Gehäuses 1 gleichzeitig die schraubenlose Halterung der Verdrahtungsplatte 8 in der Nut 16b bewirkt, wobei die Verdrahtungsplatte 8 infolge der Ausbildung mit im Teilungsraster angeordneten Aussparungen gleichzeitig die Funktion einer sonst vorzusehenden zweiten Rasterschiene ausübt, die anstelle der Verdrahtungsplatte 8 in die Nut 16b eingesetzt werden könnte. Die Aussparungen der gemeinsamen Verdrahtungsplatte 8 sind etwa in Höhe der Führungsschienen angeordnet und als Langlöcher ausgebildet, die sich mit ihrer Längsrichtung senkrecht zur Ebene der Trägerplatte erstrecken.

Die schraubenlose Halterung der aus elastischem Kunststoff bestehenden Führungsschienen 7 erfolgt durch zwei an deren Unterseite, also an der der Trägerplatte 10 zugewandten Seite vorgesehene Einschnapphaken 27, welche aufgrund der vorteilhaften Ausbildung der C-Profilschienen 14 in diese einrasten.

**Patentansprüche**

1. Einrichtung zur Fixierung von Führungsschienen für elektrische Inneneinbauten auf einer Profil-Trägerplatte, mit mindestens einer aus Kunststoff bestehenden Rasterschiene, die an der den Führungsschienen zugekehrten Seite mit einem Teilungsraster und Kennzeichnungen z.B. in Form von Zählnummern ausgebildet und in eine mit mindestens einer Hinterschneidung versehene Nut der Profil-Trägerplatte eingesetzt ist, **gekennzeichnet** durch folgende Merkmale:
a) die Rasterschiene (6) besteht aus einem im Querschnitt etwa U-förmigen Teil mit federnden Seitenschenkeln 20 an einem das Teilungsraster aufweisenden Mittelteil (21),
b) die Rasterschiene (6) ist mit ihren Seitenschenkeln (20) von oben her in die Nut (16a,16b) der Profil-Trägerplatte (10) einsetzbar,
c) mindestens ein Seitenschenkel (20) ist an seinem freien Ende mit einem nach außen gerichteten, sich in Längsrichtung der Rasterschiene (6) erstreckenden und an der Hinterschneidung (17,18) der Nut (16a,16b) einrastenden Widerhaken (22) ausgebildet,
d) die Nut (16a,16b) der Profil-Trägerplatte (10) ist außerhalb des die Inneneinbauten aufnehmenden Bereiches am Anfang bzw. Ende der Führungsschienen (7) vorgesehen,
e) die Breite der Öffnung der Nut (16a,16b) entspricht etwa dem Abstand der Außenflächen der Seitenschenkel (20) der Rasterschiene (6),
f) die Führungsschienen (7) sind lediglich mit einem an ihrem Anfang bzw. Ende vorgesehenen und auf die Rasterschiene (6) zu gerichteten Haken (26a,26b) in das als Lochraster ausgebildete Teilungsraster der Rasterschiene (6) eingehängt.

2. Einrichtung nach Anspruch 1, **dadurch gekennzeichnet**, daß die Seitenschenkel (20) der Rasterschiene (6) etwas nach außen gespreizt sind, so daß sie mit dem Mittelteil (21) einen Winkel von etwas mehr als 90° einschließen.

3. Einrichtung nach Anspruch 1 oder 2, **dadurch gekennzeichnet**, daß beide Seitenschenkel (20) der Rasterschiene (6) an ihrem freien Ende mit einem Widerhaken (22) ausgebildet sind, und daß die Profil-Trägerplatte (10) mit einer weiteren, der ersten Hinterschneidung (17) der Nut (16a,16b) gegenüberliegenden Hinterschneidung (18) versehen ist.

4. Einrichtung nach Anspruch 3, **dadurch gekennzeichnet**, daß die weitere Hinterschneidung (18) von der äußeren Schulter einer C-Profilschiene (14) gebildet ist, die liegend auf einem zur Ebene der Profil-Trägerplatte (10) senkrechten Steg (13) angeordnet ist.

5. Einrichtung nach Anspruch 4, **dadurch gekennzeichnet**, daß die Höhe (h) der Seitenschenkel (20) der Rasterschiene (6) etwa gleich der Höhe (H) der von einem Steg (13) mit C-Profilschiene (14) gebildeten Profilrippe (11) ist.

6. Einrichtung nach einem der Ansprüche 1 bis 5, **dadurch gekennzeichnet**, daß die Höhe (h) der Seitenschenkel (20) der Rasterschiene (6) etwa gleich der doppelten Breite des Mittelteiles (21) ist.

7. Einrichtung nach einem der vorhergehenden Ansprüche, **dadurch gekennzeichnet**, daß die Höhe (h) der Seitenschenkel (20) der Rasterschiene (6) und die Tiefe der Nut (16a,16b) so gewählt sind, daß die Seitenschenkel maximal bis etwa zur Hälfte in die Nut eintauchen.

8. Einrichtung nach einem der vorhergehenden Ansprüche, **dadurch gekennzeichnet**, daß die Länge (l) der Widerhaken (22) an den Seitenschenkeln (20) der Rasterschiene (6) etwa gleich dem Höhenabstand der Hinterschneidungen (17,18) der Nut (16a,16b) von der Ebene der Profil-Trägerplatte (10) ist.

9. Einrichtung nach einem der vorhergehenden Ansprüche, **dadurch gekennzeichnet**, daß die Löcher des Teilungsrasters von sich mit ihrer Längsrichtung parallel zueinander und senkrecht zu den Seitenschenkeln der Rasterschiene (6) erstreckenden Langlöchern (23) gebildet sind.

10. Einrichtung nach Anspruch 9, **dadurch gekennzeichnet**, daß sich die Langlöcher (23) in ihrer Längsrichtung über die gesamte Breite des Mittelteiles (21) der Rasterschiene (6) erstrecken.

11. Einrichtung nach einem der vorhergehenden Ansprüche, **dadurch gekennzeichnet**, daß die Kennzeichnungen auf den zwischen den Löchern (23) des Teilungsrasters stehenbleibenden Stegen (24) vorgesehen sind.

12. Einrichtung nach einem der vorhergehenden Ansprüche, **dadurch gekennzeichnet**, daß an beiden Seitenschenkeln (20) der Rasterschiene (6) zusätzliche Kennzeichnungen (25) für das Teilungsraster vorgesehen sind.

13. Einrichtung nach Anspruch 12, **dadurch gekennzeichnet**, daß die zusätzlichen Kennzeichnungen (25) in Höhe einer Zehnerteilung vorgesehen und von einem längeren Strich oder einer Rippe gebildet sind.

14. Einrichtung nach Anspruch 12 oder 13, **dadurch gekennzeichnet**, daß die zusätzlichen Kennzeichnungen (25) in Höhe einer Fünferteilung vorgesehen und von einem kürzeren Strich oder einer Rippe gebildet sind.

## Revendications

1. Dispositif servant à fixer des glissières pour éléments électriques incorporés sur une plaque-support profilée, comprenant au moins un rail-échelle en matière plastique, dont le côté dirigé vers les glissières est pourvu d'une échelle dont les divisions correspondent aux pas d'une grille de base, ainsi que de marquages, par exemple sous forme de nombres qui se suivent, et qui est disposé dans une rainure de la plaque-support profilée, rainure qui présente au moins une partie en retrait ou rentrant, caractérisé en ce que:

a) le rail-échelle (6) est formé par une pièce de section droite à peu près en U, possédant des ailes latérales (20) élastiques reliées à une partie centrale (21) présentant l'échelle,

b) le rail-échelle (6) peut être mis en place par le haut, par l'engagement de ses ailes latérales (20) dans la rainure (16a, 16b) de la plaque-support profilée (10),

c) au moins une aile latérale (20) est pourvue, à son extrémité libre, d'un rebord (22) dirigé vers l'extérieur, s'étendant dans le sens de la longueur du rail-échelle (6) et s'accrochant dans le rentrant (17, 18) de la rainure (16a, 16b),

d) la rainure (16a, 16b) de la plaque-support profilée (10) est prévue en dehors de la zone recevant les éléments intérieurs, au début et à la fin des glissières (7),

e) la largeur de l'ouverture de la rainure (16a, 16b) correspond à peu près à l'écartement des faces externes des ailes latérales (20) du rail-échelle (6),

f) les glissières (7) sont simplement suspendues dans l'échelle du rail (6), formée par une perforation régulière, par des crochets (26a, 26b) prévus au début et à la fin des glissières et dirigés vers le rail-échelle (6).

2. Dispositif selon la revendication 1, caractérisé en ce que les ailes latérales (20) du rail-échelle (6) sont légèrement écartées vers l'extérieur, de sorte qu'elles forment un angle légèrement supérieur à 90° avec la partie centrale (21).

3. Dispositif selon la revendication 1 ou 2, caractérisé en ce que les deux ailes latérales (20) du rail-échelle (6) sont pourvues d'un rebord (22) à leur extrémité libre et que la plaque-support profilée (10) est pourvue d'un rentrant (18) supplémentaire, situé en regard du premier rentrant (17) de la rainure (16a, 16b).

4. Dispositif selon la revendication 3, caractérisé en ce que le rentrant supplémentaire (18) est formé par l'épaulement extérieur d'un rail profilé en C (14) qui est disposé longitudinalement sur une âme (13) perpendiculaire au plan de la plaque-support profilée (10).

5. Dispositif selon la revendication 4, caractérisé en ce que la hauteur (h) des ailes latérales (20) du rail-échelle (6) est environ égale à la hauteur (H) d'une nervure profilée (11) composée d'une âme (13) et d'un rail profilé en C (14).

6. Dispositif selon une des revendications 1 à 5, caractérisé en ce que la hauteur (h) des ailes latérales (20) du rail-échelle (6) est environ égale au double de la largeur de la partie centrale (21).

7. Dispositif selon une des revendications précédentes, caractérisé en ce que la hauteur (h) des ailes latérales (20) du rail échelle (6) et la profondeur de la rainure (16a, 16b) ont été choisies de manière que les ailes latérales pénètrent tout au plus sur la moitié environ dans la rainure.

8. Dispositif selon une des revendications précédentes, caractérisé en ce que la longueur (1) des rebords (22) sur les ailes latérales (20) du railéchelle (6) est environ égale à la hauteur des rentrants (17, 18) de la rainure (16a, 16b) à partir du plan de la plaque-support profilée (10).

9. Dispositif selon une des revendications précédentes, caractérisé en ce que les trous de l'échelle sont formés par des trous oblongs (23) s'étendant parallèlement entre eux et perpendiculairement aux ailes latérales du rail-échelle (6) par leur direction longitudinale.

10. Dispositif selon la revendication 9, caractérisé en ce que les trous oblongs (23) s'étendent, dans le sens de leur longueur, sur toute la largeur de la partie centrale (21) du rail-échelle (6).

11. Dispositif selon une des revendications précédentes, caractérisé en ce que les marquages sont prévus sur les barrettes (24) qui subsistent entre les trous (23) de l'échelle.

12. Dispositif selon une des revendications précédentes, caractérisé en ce que des marquages supplémentaires (25) pour l'échelle sont prévus sur les deux ailes latérales (20) du rail-échelle (6).

13. Dispositif selon la revendication 12, caractérisé en ce que les marquages supplémentaires (25) sont formés à la hauteur de chaque dixième division de l'échelle et sont formés par un trait relativement long ou par une nervure.

14. Dispositif selon la revendication 12 ou 13, caractérisé en ce que les marquages supplémentaires (25) sont prévus à la hauteur de chaque cinquième division de l'échelle et sont formés par un trait relativement court ou par une nervure.

## Claims

1. Device for mounting guide rails for electrical interior modules on a section mounting board, having at least one standard grid rail consisting of plastic, which, on the side facing the guide rails, is constructed with a dividing grid and identifying markings, e.g. in the form of serial numbers, and is inserted in a groove of the section mounting board provided with at least one undercut, characterized by the following features:

a) The standard grid rail (6) consists of a part, approximately U-shaped in cross-section, having resilient side limbs (20) on a central part (21) having the dividing grid,

b) the standard grid rail (6) can be inserted from above with its side limbs (20) into the groove (16a, 16b) of the section mounting board (10),

c) at least one side limb (20) is constructed at its free end with a barbed hook (22), which points outwards and extends in the longitudinal direction of the standard grid rail (6) and engages with the undercut (17, 18) of the groove (16a, 16b),

d) the groove (16a, 16b) of the section mounting board (10) is provided at the start or end of the guide rails (7) outside the zone accommodating the interior modules,

e) the width of the opening of the groove (16a, 16b) corresponds approximately to the spacing of the external faces of the side limbs (20) of the standard grid rail (6),

f) the guide rails (7) are slung in the dividing grid of the standard grid rail (6), which dividing grid is which is provided at their start or end and is directed towards the standard grid rail (6).

2. Device according to Claim 1, characterized in that the side limbs (20) of the standard grid rail (6) are spread outwards a little, so that they enclose an angle of a little more than 90° with the central part (21).

3. Device according to Claim 1 or 2, characterized in that both side limbs (20) of the standard grid rail (6) are constructed at their free end with a barbed hook (22), and in that the section mounting board (10) is provided with a further undercut (18) opposite the first undercut (17) of the groove (16a, 16b).

4. Device according to Claim 3, characterized in that the further undercut (18) is formed by the external shoulder of a C-section rail (14), which is arranged lying on a web (13) perpendicular to the plane of the section mounting board (10).

5. Device according to Claim 4, characterized in that the height (h) of the side limbs (20) of the standard grid rail (6) is approximately equal to the height (H) of the section rib (11) formed by a web (13) with the C-section rail (14).

6. Device according to one of Claims 1 to 5, characterized in that the height (h) of the side limbs (20) of the standard grid rail (6) is approximately equal to double the width of the central part (21).

7. Device according to one of the preceding claims, characterized in that the height (h) of the side limbs (20) of the standard grid rail (6), and the depth of the groove (16a, 16b) are chosen so that the side limbs fit into the groove to at most approximately half.

8. Device according to one of the preceding claims, characterized in that the length (1) of the barbed hook (22) on the side limbs (20) of the standard grid rail (6) is approximately equal to the vertical interval of the undercuts (17, 18) of the groove (16a, 16b) from the plane of the section mounting board (10).

9. Device according to one of the preceding claims, characterized in that the holes of the dividing grid are formed by oblong holes (23) extending with their longitudinal direction parallel to one another and perpendicular to the side limbs of the standard grid rail (6).

10. Device according to Claim 9, characterized in that the oblong holes (23) extend in their longitudinal direction over the entire width of the central part (21) of the standard grid rail (6).

11. Device according to one of the preceding claims, characterized in that the identifying markings are provided on the webs (24) remaining between the holes (23) of the dividing grid.

12. Device according to one of the preceding claims, characterized in that additional identifying markings (25) for the dividing grid are provided at both side limbs (20) of the standard grid rail (6).

13. Device according to Claim 12, characterized in that the additional identifying markings (25) are provided at every tenth division, and are formed by quite a long line or by a rib.

14. Device according to Claim 12 or 13, characterized in that the additional identifying markings (25) are provided at every fifth division, and are formed by quite a short line or by a rib.

# FIG 1

# FIG 2